(19) Europäisches Patentamt
European Patent Office
Office européen des brevets

(11) **EP 3 792 327 B1**

(12) **EUROPEAN PATENT SPECIFICATION**

(45) Date of publication and mention
of the grant of the patent:
**28.05.2025 Bulletin 2025/22**

(51) International Patent Classification (IPC):
***C09K 3/14*** *(2006.01)* ***C09G 1/02*** *(2006.01)*

(21) Application number: **20191572.5**

(52) Cooperative Patent Classification (CPC):
**C09K 3/1463; C09G 1/02; C09K 3/1409**

(22) Date of filing: **18.08.2020**

(54) **POLISHING COMPOSITION, POLISHING METHOD AND METHOD FOR MANUFACTURING SEMICONDUCTOR SUBSTRATE**

POLIERZUSAMMENSETZUNG, POLIERVERFAHREN UND VERFAHREN ZUR HERSTELLUNG EINES HALBLEITERSUBSTRATS

COMPOSITION DE POLISSAGE, PROCÉDÉ DE POLISSAGE ET PROCÉDÉ DE FABRICATION D'UN SUBSTRAT À SEMICONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.09.2019 JP 2019165111**
**27.02.2020 JP 2020032253**
**01.06.2020 JP 2020095479**

(43) Date of publication of application:
**17.03.2021 Bulletin 2021/11**

(73) Proprietor: **Fujimi Incorporated**
**Kiyosu-shi, Aichi 452-8502 (JP)**

(72) Inventors:
• **MAE, Ryota**
**Kiyosu-shi, Aichi 452-8502 (JP)**
• **ONISHI, Shogo**
**Kiyosu-shi, Aichi 452-8502 (JP)**

(74) Representative: **Grünecker Patent- und Rechtsanwälte**
**PartG mbB**
**Leopoldstraße 4**
**80802 München (DE)**

(56) References cited:
**EP-A1- 3 261 114** **EP-A2- 2 017 318**
**EP-A2- 2 489 714** **KR-A- 20190 060 226**

**Description**

**BACKGROUND**

1. Technical Field

The present invention relates to a polishing composition, a polishing method, and a method for manufacturing a semiconductor substrate.

2. Description of Related Arts

With recent advancement in multi-layered interconnect on the surface of a semiconductor substrate, so-called chemical mechanical polishing (CMP) technology has been employed in the process of manufacturing devices, in order to physically planarize the semiconductor substrate. CMP is a method for planarizing the surface of an object to be polished (polishing target) such as a semiconductor substrate, using a polishing composition (slurry) that contains an abrasive grain such as silica, alumina, ceria or the like, an anticorrosive, a surfactant and so forth, and is specifically used in steps including shallow trench isolation (STI), planarization of interlayer insulating film (ILD film), formation of tungsten plug, formation of multi-layered interconnect composed of copper and low dielectric constant (low-k) film, and the like.

For example, JP-A-2001-185516 discloses a polishing composition that includes a water-soluble polymer added alkylene oxide, polyacrylic acid, and an abrasive grain. This technique reportedly enables high speed polishing, while suppressing occurrence of scratches in association with polishing, on the surface of the object to be polished.

EP 3 261 114 A1 provides examples of relevant polishing compositions.

**SUMMARY**

It has been found that the technique described in JP-A-2001-185516 is, however, insufficient in terms of enhancement of the polishing speed.

It is therefore an object of the present invention to provide a polishing composition capable of polishing an object to be polished at high polishing speed.

The present inventors have earnestly studied to solve the above issues. As a result, they have found that the above issue can be solved by a polishing composition according to claim 1.

**DETAILED DESCRIPTION**

Embodiments of the present invention will be described below. The present invention is, however, not solely limited to the embodiments below. All operations and measurements of physical properties and so forth are carried out under conditions involving room temperature (20 to 25°C) and a relative humidity of 40 to 50%RH, unless otherwise specifically noted. All notations in this patent specification in the form of "X to Y" means "X or more and Y or less".

<Polishing Composition>

The present invention is a polishing composition used for polishing an object to be polished, and has a composition as defined in claim 1.

The reason why the polishing composition of the present invention can express the aforementioned effects, although remaining partially unclear, is presumed as below.

The polishing composition is normally considered to polish the object to be polished, on the basis of physical action exerted by abrasion on the surface of substrate, chemical action exerted by ingredients other than the abrasive grain on the surface of substrate, and combination of these actions. Hence, shape and type of the abrasive grain will largely affect the polishing speed as a consequence.

The polishing composition of the present invention contains an abrasive grain having a predetermined shape and a predetermined particle size distribution. That is, the abrasive grain used in the polishing composition is composed of an irregular shaped particle proven by an aspect ratio of larger than 1.1, and a particle having a broad particle size distribution proven by $D90/D50$ of 1.6 or larger. Owing to the irregular shape, the abrasive grain is inhibited from tumbling on the polishing surface, but instead can remain on the polishing surface to thoroughly apply mechanical force for successful polishing. Moreover, such broad particle size distribution of the abrasive grain means that there are relatively small abrasive grains and relatively large abrasive grains contained together. The relatively small abrasive grains, upon brought into contact with the relatively large abrasive grains, are inhibited from tumbling on the polishing surface. The relatively small abrasive grains are therefore enabled to exert enough mechanical force during polishing onto the object to be polished, to thereby further enhance the polishing speed on the object to be polished.

The abrasive grain contained in the polishing composition of the present invention has a negative value of zeta ($\zeta$) potential. In other words, the abrasive grain having a negative zeta potential value is used in the polishing composition. Now the anionic water-soluble polymer used in the polishing composition of the present invention is likely to adhere, for its polymer nature, on the surface of a polishing pad (polyurethane, for example). Upon adhesion of the anionic water-soluble polymer onto the polishing pad, the surface of the polishing pad will have a negative zeta potential. More specifically, the zeta potential of the surface of the pad having been positive will shift towards the negative side upon adhesion of the anionic water-soluble polymer, meanwhile the zeta potential of the surface of the pad having been negative will increase the absolute value thereof upon adhesion of the anionic water-soluble polymer. Hence, when the polishing composition is used for polishing the object to be polished, a repulsive force is generated between the negative charges of the polishing pad in contact with the polishing composition and abrasive grain in the polishing composition. Such repulsion is supposed to further enhance the polishing speed on the object to be polished.

The polishing composition of the present invention further contains a basic inorganic compound. For example, the basic inorganic compound can increase electrical conductivity of the polishing composition than a basic organic compound can. Hence the polishing speed using the polishing composition is supposedly further enhanced.

As described above, the polishing composition of the present invention is considered to have further improved polishing performance of the abrasive grain, as a result of inclusion of the high performance abrasive grain with the predetermined shape and the predetermined particle size distribution, in combination with the anionic water-soluble polymer and the basic inorganic compound. Note, however, that such mechanism remains a matter of speculation, and as a matter of course does not limit the technical scope of the present invention.

[Object to be polished]

Materials contained in the object to be polished with the polishing composition of the present invention are exemplified by, but not specifically limited to, silicon oxide ($SiO_2$), silicon nitride (SiN), silicon carbonitride (SiCN), polycrystalline silicon (polysilicon), amorphous silicon, metal, SiGe, and the like.

The object to be polished in the present invention preferably contains silicon oxide or silicon nitride, and more preferably contains silicon oxide. Hence the polishing composition of the present invention is preferably used for applications where the object to be polished, containing silicon oxide or silicon nitride, is polished, and is more preferably used for applications where the object to be polished, containing silicon oxide, is polished.

Films containing silicon oxide are exemplified by TEOS (Tetraethyl Orthosilicate) type silicon oxide film (also simply referred to as "TEOS film", hereinafter) which is produced by using tetraethyl orthosilicate as a precursor, HDP (High Density Plasma) film, USG (Undoped Silicate Glass) film, PSG (Phosphorus Silicate Glass) film, BPSG (Boron-Phospho Silicate Glass) film, RTO (Rapid Thermal Oxidation) film, and the like.

Films containing metal are exemplified by tungsten (W) film, titanium nitride (TiN) film, ruthenium (Ru) film, platinum (Pt) film, gold (Au) film, hafnium (Hf) film, cobalt (Co) film, nickel (Ni) film, copper (Cu) film, aluminum (Al) film, tantalum (Ta) film, and the like. From the viewpoint of improving the electrical conductivity, preferably used is W film, TiN film, Ru film, Pt film or Au film, more preferably used is W film or TiN film, and most preferably used is W film. In one embodiment, the polishing composition of the present invention is also suitably applicable to an object to be polished containing metal (tungsten, for example).

[Abrasive Grain]

The polishing composition of the present invention contains an abrasive grain. Types of abrasive grain used in the polishing composition of the present invention are exemplified by, but not specifically limited to, oxides such as silica, alumina, zirconia and titania. Only one kind of abrasive grain may be used independently, or two or more kinds may be used in a combined manner. Each abrasive grain may be a commercial product or synthetic product. The abrasive grain is preferably silica or alumina. That is, the polishing composition of the present invention preferably contains silica (preferably colloidal silica, described later) or alumina, as the abrasive grain.

In the polishing composition of the present invention, the abrasive grain has a negative (minus) value of zeta potential, an aspect ratio of the abrasive grain is larger than 1.1, and when viewed in a particle size distribution determined by laser diffraction/scattering method, ratio D90/D50, where D90 represents a particle diameter at which the cumulative particle mass integrated from the small particle side accounts for 90% of the total particle mass, and D50 represents a particle diameter at which the cumulative particle mass integrated from the small particle side accounts for 50% of the total particle mass, is 1.6 or larger Preferred modes of these properties of the abrasive grain may occasionally vary depending on types of abrasive grains to be employed. In the description below, any preferred mode variable depending on types of abrasive grains will be explained on all such occasions, whereas all other modes without special notation on the types of abrasive grain will be understood to be a common mode irrespective of the types of abrasive grain.

The abrasive grain used for the polishing composition of the present invention has a negative value of zeta potential. Now "zeta ($\zeta$) potential" is a potential difference produced at the interface between adjoining solid and liquid under relative motion. The polishing composition of the present invention can enhance the polishing speed on the object to be polished, as a result of negative charge owned by the abrasive grain. The zeta potential of the abrasive grain is preferably -80 mV or larger and -5 mV or smaller, and more preferably -60 mV or larger and -30 mV or smaller. With the zeta potential controlled within these ranges, the abrasive grain can enhance the polishing speed on the object to be polished.

For the abrasive grain composed of silica, the zeta potential of the abrasive grain is preferably -80 mV or larger and -20 mV or smaller, and more preferably -60 mV or larger and -30 mV or smaller. With the zeta potential controlled within these ranges, the abrasive grain (silica) can enhance the polishing speed on the object to be polished.

For the abrasive grain composed of alumina, the zeta potential of the abrasive grain is preferably -80 mV or larger and -5 mV or smaller, and more preferably - 60 mV or larger and -20 mV or smaller. With the zeta potential controlled within these ranges, the abrasive grain (alumina) can enhance the polishing speed on the object to be polished.

The zeta potential of the abrasive grain in the polishing composition is determined by loading the polishing composition on ELS-Z2 from Otsuka Electronics Co., Ltd., performing measurement according to the Doppler method (electrophoretic light scattering method) using a flow cell at a measurement temperature of 25°C, and analyzing the obtained data using the Smoluchowski equation.

The aspect ratio of the abrasive grain used in the polishing composition of the present invention is larger than 1.1. With the aspect ratio larger than 1.1, the abrasive grain will be inhibited from tumbling on the polishing surface, and can enhance the polishing speed. With the aspect ratio controlled to 1.1 or smaller, the abrasive grain will have degraded polishing speed. The aspect ratio of the abrasive grain is preferably 1.2 or more, and more preferably larger than 1.2. The upper limit of aspect ratio of the abrasive grain is preferably, but not limited to, smaller than 5, which is more preferably 4.5 or smaller, and even more preferably 4 or smaller. Within these ranges, the polishing speed may further be enhanced. Now the aspect ratio of abrasive grain is determined by assuming a smallest rectangle that circumscribes each abrasive grain particle on an image taken under an electron microscope, dividing the long side (long diameter) by the short side (short diameter) for each rectangle to obtain a value, and averaging the values, which is determinable using any of known image analysis software. More specifically, 100 abrasive grains are selected on an image taken under a scanning electron microscope (SEM) (Model SU8000, from Hitachi High-Tech Corporation), the long diameters and the short diameters of them are measured and averaged, and the aspect ratio is calculated by a formula "averaged long diameter/averaged short diameter". Methods of measurement and calculation of the aspect ratio of the abrasive grain will be detailed later in EXAMPLES.

For the abrasive grain composed of silica, the aspect ratio of the abrasive grain is preferably 1.2 or larger, and is more preferably larger than 1.2. For the abrasive grain composed of silica, the upper limit of the aspect ratio of the abrasive grain is preferably, but not specifically limited to, smaller than 2.0, more preferably 1.8 or smaller, and even more preferably 1.5 or smaller. With the aspect ratio controlled within the aforementioned ranges, the abrasive grain (silica) can further enhance the polishing speed.

For the abrasive grain composed of alumina, the aspect ratio of the abrasive grain is preferably 2 or larger, and is more preferably larger than 2.5. For the abrasive grain composed of alumina, the upper limit of the aspect ratio of the abrasive grain is preferably, but not specifically limited to, smaller than 5, more preferably 4.5 or smaller, and even more preferably 4 or smaller. With the aspect ratio controlled within the aforementioned ranges, the abrasive grain (alumina) can further enhance the polishing speed.

The abrasive grain used for the polishing composition of the present invention has, when viewed in a particle size distribution determined by laser diffraction/scattering method, ratio D90/D50, where D90 represents a particle diameter at which the cumulative particle mass integrated from the small particle side accounts for 90% of the total particle mass, and D50 represents a particle diameter at which the cumulative particle mass integrated from the small particle side accounts for 50% of the total particle mass, is 1.6 or larger. Hence in the polishing composition, there are relatively small abrasive grains and relatively large abrasive grains contained together. The relatively small abrasive grains, upon brought into contact with the relatively large abrasive grains, are inhibited from tumbling on the polishing surface. The relatively small abrasive grains are therefore enabled to exert enough mechanical force during polishing onto the object to be polished, to thereby further enhance the polishing speed on the object to be polished. If D90/D50 is smaller than 1.3, the polishing speed will degrade.

D90/D50 is 1.6 or larger. Within these ranges, the polishing speed may further be enhanced. In the particle size distribution of the abrasive grain in the polishing composition, when determined by laser diffraction/scattering method, the upper limit of D90/D50, which is a ratio of a particle diameter (D90) at which cumulative particle mass integrated from the small particle side accounts for 90% of the total particle mass, and a particle diameter (D50) at which cumulative particle mass integrated from the small particle side accounts for 50% of the total particle mass, is preferably 4 or smaller, but not specifically limited thereto. Within the range, any defects such as scratches possibly remain on the surface of the object to be polished, after polished with the polishing composition, can be suppressed.

For the abrasive grain composed of silica, D90/D50 is 1.6 or larger. Within these ranges, the polishing speed may further be enhanced. For the abrasive grain composed of silica, the upper limit of D90/D50 is preferably 2 or smaller, but not specifically limited thereto. Within the range, any defects such as scratches possibly remain on the surface of the object to be polished, after polished with the polishing composition, can be suppressed.

For the abrasive grain composed of alumina, D90/D50 is preferably 2 or larger. Within these ranges, the polishing speed may further be enhanced. For the abrasive grain composed of alumina, the upper limit of D90/D50 is preferably 4 or smaller, but not specifically limited thereto. Within the range, any defects such as scratches possibly remain on the surface of the object to be polished, after polished with the polishing composition, can be suppressed.

Although the size of abrasive grain is not specifically limited, the lower limit of average primary particle size of the abrasive grain, which is determined by image analysis on a photograph observed under a scanning electron microscope, is preferably 10 nm or larger, more preferably 30 nm or larger, and even more preferably 50 nm or larger. Meanwhile, the upper limit of average primary particle size of the abrasive grain in the polishing composition of the present invention is preferably 3000 nm or smaller, more preferably 2500 nm or smaller, yet more preferably 2000 nm or smaller, and particularly preferably 1500 nm or smaller. Within the range, any defects such as scratches possibly remain on the surface of the object to be polished, after polished with the polishing composition, can be suppressed. That is, the average primary particle size of the abrasive grain is preferably 10 nm or larger and 3000 nm or smaller, more preferably 30 nm or larger and 2500 nm or smaller, even more preferably 50 nm or larger and 2000 nm or smaller, and particularly preferably 50 nm or larger and 1500 nm or smaller. Note that the average primary particle size of the abrasive grain is calculated on the basis of specific surface area of the abrasive grain, typically measured by the BET method.

For the abrasive grain composed of silica, the lower limit of average primary particle size of the abrasive grain is preferably 10 nm or larger, more preferably 30 nm or larger, and even more preferably 50 nm or larger. The upper limit of average primary particle size of the abrasive grain in the polishing composition of the present invention is, for the abrasive grain composed of silica, preferably 120 nm or smaller, more preferably 100 nm or smaller, and even more preferably 80 nm or smaller. Within the range, any defects such as scratches possibly remain on the surface of the object to be polished, after polished with the polishing composition, can be suppressed. That is, for the abrasive grain composed of silica, the average primary particle size of the abrasive grain is preferably 10 nm or larger and 120 nm or smaller, more preferably 30 nm or larger and 100 nm or smaller, and even more preferably 50 nm or larger and 80 nm or smaller.

For the abrasive grain composed of alumina, the lower limit of average primary particle size of the abrasive grain is preferably 100 nm or larger, more preferably 250 nm or larger, and even more preferably 300 nm or larger. The upper limit of average primary particle size of the abrasive grain in the polishing composition of the present invention is, for the abrasive grain composed of alumina, preferably 3000 nm or smaller, more preferably 2500 nm or smaller, even more preferably 2000 nm or smaller, and particularly preferably 1500 nm or smaller. Within the range, any defects such as scratches possibly remain on the surface of the object to be polished, after polished with the polishing composition, can be suppressed. That is, for the abrasive grain composed of alumina, the average primary particle size of the abrasive grain is preferably 100 nm or larger and 3000 nm or smaller, more preferably 250 nm or larger and 2500 nm or smaller, even more preferably 300 nm or larger and 2000 nm or smaller, and particularly preferably 300 nm or more and 1500 nm or smaller.

The lower limit of average secondary particle size of the abrasive grain, in the polishing composition of the present invention, is 70 nm or larger. Meanwhile, the upper limit of the average secondary particle size of the abrasive grain, in polishing composition of the present invention, is preferably 4000 nm or smaller, more preferably 3500 nm or smaller, even more preferably 3000 nm or smaller, yet more preferably 2500 nm or smaller, and most preferably 2000 nm or smaller. Within the range, any defects such as scratches possibly remain on the surface of the object to be polished, after polished with the polishing composition, can be suppressed. That is, the average secondary particle size of the abrasive grain is preferably 70 nm or larger and 2500 nm or smaller, and most preferably 70 nm or larger and 2000 nm or smaller. Note that the average secondary particle size of the abrasive grain may be measured by a dynamic light scattering method represented by the laser diffraction/scattering method. That is, the average secondary particle size of the abrasive grain is equivalent to the particle diameter D50 at which the cumulative particle mass integrated from the small particle side accounts for 50% of the total particle mass, in the particle size distribution of the abrasive grain determined by the laser diffraction/scattering method.

For the abrasive grain composed of silica, the lower limit of the average secondary particle size of abrasive grain in the polishing composition of the present invention is 70 nm or larger. For the abrasive grain composed of silica, the upper limit of the average secondary particle size of the abrasive grain in the polishing composition of the present invention is preferably 250 nm or smaller, more preferably 200 nm or smaller, even more preferably 150 nm or smaller, yet more preferably 120 nm or smaller, and most preferably 100 nm or smaller. Within the range, any defects such as scratches possibly remain on the surface of the object to be polished, after polished with the polishing composition, can be suppressed. That is, for the abrasive grain composed of silica, the average secondary particle size of abrasive grain is preferably 70 nm or larger and 120 nm or smaller, and most preferably 70 nm or larger and 100 nm or smaller.

For the abrasive grain composed of alumina, the lower limit of the average secondary particle size of abrasive grain in the polishing composition of the present invention is preferably 100 nm or larger, more preferably 200 nm or larger, even more preferably 300 nm or larger, and yet more preferably 500 nm or larger. For the abrasive grain composed of alumina, the upper limit of the average secondary particle size of the abrasive grain in the polishing composition of the present invention is preferably 4000 nm or smaller, more preferably 3500 nm or smaller, even more preferably 3000 nm or smaller, yet more preferably 2500 nm or smaller, and most preferably 2000 nm or smaller. Within the range, any defects such as scratches possibly remain on the surface of the object to be polished, after polished with the polishing composition, can be suppressed. That is, for the abrasive grain composed of alumina, the average secondary particle size of the abrasive grain is preferably 100 nm or larger and 4000 nm or smaller, more preferably 200 nm or larger and 3500 nm or smaller, even more preferably 300 nm or larger and 3000 nm or smaller, yet more preferably 400 nm or larger and 2500 nm or smaller, and most preferably 500 nm or larger and 2000 nm or smaller.

Average degree of association of the abrasive grain is preferably 6.0 or smaller, more preferably 5.0 or smaller, and even more preferably 4.0 or smaller. The smaller the average degree of association of the abrasive grain, the lesser the defects possibly produced on the surface of the object to be polished. Meanwhile, the average degree of association of the abrasive grain is preferably 1.0 or larger, and more preferably 1.2 or larger. The larger the average degree of association abrasive grain, the faster the polishing speed with the polishing composition beneficially. The average degree of association of the abrasive grain is obtained by dividing the average secondary particle size of the abrasive grain by the average primary particle size.

For the abrasive grain composed of silica, average degree of association of the abrasive grain is preferably 2.0 or smaller, more preferably 1.8 or smaller, and even more preferably 1.6 or smaller. The smaller the average degree of association of the abrasive grain, the lesser the defects possibly produced on the surface of the object to be polished. For the abrasive grain composed of silica, the average degree of association of the abrasive grain is preferably 1.0 or larger, and more preferably 1.2 or larger. The larger the average degree of association abrasive grain, the faster the polishing speed with the polishing composition beneficially.

For the abrasive grain composed of alumina, average degree of association of the abrasive grain is preferably 6.0 or smaller, more preferably 5.0 or smaller, and even more preferably 4.0 or smaller. The smaller the average degree of association of the abrasive grain, the lesser the defects possibly produced on the surface of the object to be polished. For the abrasive grain composed of alumina, the average degree of association of the abrasive grain is preferably 1.0 or larger, more preferably 1.5 or larger, and most preferably 2.0 or larger. The larger the average degree of association abrasive grain, the faster the polishing speed with the polishing composition beneficially.

Sizes of the abrasive grain (average particle size, aspect ratio, D90/D50, etc.) may properly be controlled by suitably selecting the method for manufacturing the abrasive grain, for example.

Silica, used as the abrasive grain, is preferably colloidal silica. The method for manufacturing colloidal silica is exemplified by the sodium silicate method and the sol-gel method. Any colloidal silica, manufactured by either method for manufacturing, is suitably used as the abrasive grain in the present invention. The colloidal silica manufactured by the sol-gel method is, however, preferred from the viewpoint of reducing a metal impurity. The colloidal silica manufactured by the sol-gel method is preferred since it has low contents of the metal impurity, which are likely to diffuse into semiconductors, and the corrosive ions such as chloride ion. Manufacture of the colloidal silica by the sol-gel method may employ any of known techniques. More specifically, the colloidal silica is obtainable by using a hydrolyzable silicon compound (alkoxysilane or derivative thereof, for example) as a starting material, and by subjecting it to a hydrolysis/condensation reaction.

The colloidal silica may have a cationic group. The colloidal silica having a cationic group is preferably exemplified by colloidal silicas having amino groups immobilized on the surface thereof. A method for manufacturing such colloidal silicas having a cationic group is exemplified by a method described in JP-A-2005-162533, by which a silane coupling agent having an amino group, such as aminoethyltrimethoxysilane, aminopropyltrimethoxysilane, aminoethyltriethoxysilane, aminopropyltriethoxysilane, aminopropyldimethylethoxysilane, aminopropylmethyldiethoxysilane or aminobutyltriethoxysilane, is immobilized onto the surface of the abrasive grain. In this way, the colloidal silica having amino groups immobilized on the surface thereof (amino group-modified colloidal silica) may be obtained.

The colloidal silica may have an anionic group. The colloidal silica having an anionic group is preferably exemplified by colloidal silicas having anionic groups such as carboxylic acid group, sulfonic acid group, phosphonic acid group and aluminic acid group, immobilized on the surface thereof. A method for manufacturing such colloidal silicas having an anionic group is exemplified by, but not specifically limited to, a method by which a silane coupling agent having an anionic group at the terminal is allowed to react with colloidal silica.

As a specific example, if sulfonic acid group is immobilized to the colloidal silica, for example, a method described in "Sulfonic acid-functionalized silica through of thiol groups", Chem. Commun. 246-247 (2003) can be adopted. More specifically, by coupling a silane coupling agent having thiol groups such as 3-mercaptopropyltrimethoxysilane with the colloidal silica, and subsequently oxidizing the thiol groups with hydrogen peroxide, the colloidal silica with the sulfonic acid group immobilized to its surface can be obtained.

Alternatively, if carboxylic acid group is immobilized to the colloidal silica, for example, a method described in "Novel Silane Coupling Agents Containing a Photolabile 2-Nitrobenzyl Ester for Introduction of a Carboxy Group on the Surface of Silica Gel", Chemistry Letters, 3, 228-229 (2000)" can be adopted. More specifically, by coupling a silane coupling agent containing photolabile 2-nitrobenzyl ester with the colloidal silica and subsequently irradiating the colloidal silica with light, the colloidal silica with carboxylic acid group immobilized to its surface can be obtained.

Alumina, used as the abrasive grain, is suitably selectable from known types of alumina. The known types of alumina are exemplified by those containing at least one selected from $\alpha$-alumina, $\gamma$-alumina, $\delta$-alumina, $\theta$-alumina, $\eta$-alumina, $\kappa$-alumina, and the like. Alternatively, an alumina, so-called fumed alumina on the basis of classification by production method (typically alumina particle produced as a result of high temperature firing of alumina salt) may be used. Moreover, alumina called colloidal alumina or alumina called alumina sol (for example, alumina hydrate such as boehmite) are included in the known alumina. Alumina used as the abrasive grain in the polishing composition of the present invention may contain any single type of such alumina particles independently, or may contain two or more types of them in a combined manner. Among them, the alumina that contains $\alpha$-phase as a crystal phase (alumina that contains $\alpha$-alumina) is preferred, and alumina that contains $\alpha$-phase as a major crystal phase (alumina that contains $\alpha$-alumina as the major ingredient) is more preferred.

In this specification, alumina is determined to "contain $\alpha$-phase as a crystalline phase", when a peak assignable to $\alpha$-phase is observed at $2\theta = 25.6°$ in a powder X-ray diffraction spectrum of alumina obtained using a powder X-ray diffractometer. In addition in this specification, alumina is determined to "contain $\alpha$-phase as the major component", when $\alpha$ convertion ratio described later is larger than 50% (100% at maximum). Now the $\alpha$ convertion ratio (%) can be calculated by the equation below, using height of peak (I25.6) assignable to (012) plane of $\alpha$-phase that appears at $2\theta = 25.6°$, and height of peak (I46) assignable to $\gamma$-phase that appears at $2\theta = 46°$, in a powder X-ray diffraction spectrum obtained using a powder X-ray diffractometer.

```
[Math. 1]
α convertion ratio = [I25.6/(I25.6 + I46)] × 100    [in %]
```

The $\alpha$ convertion ratio calculated on the basis of the aforementioned measurement appears to be an almost equivalent value, either by measuring a powdery alumina which is a raw material for the polishing composition, or by measuring an alumina isolated from an already prepared polishing composition.

Method for manufacturing alumina, although suitably employable from any of known methods without special limitation, is preferably a method by which alumina free of $\alpha$-phase, such as boehmite, is fired to obtain alumina that contains $\alpha$-phase as a major crystal phase. That is, alumina is preferably the one manufactured after going through a firing process. Alumina obtained after going through the firing process may be ground into a desired size.

Alumina used as the abrasive grain may contain amorphous alumina, so long as the effects of the present invention will not be damaged.

In the present invention, shape of the abrasive grain is preferably aspherical. Specific examples of aspherical shape are exemplified by various shapes including polygonal columns such as triangular prism and quadrangular prism, column, barrel shape thickened at the center than the edges, donut shape resulted from disk punched out at the center, planer shape, so-called cocoon shape with constricted center, shape of associated spheres resulted from integration of a plurality of particles, so-called *kompeito* (Japanese star-shaped sugar candy) shape having a lot of small bumps on the surface, rugby ball shape, and the like.

The lower limit of content (concentration) of the abrasive grain, in the polishing composition according to one embodiment of the present invention, is, relative to the polishing composition, preferably 1% by mass or more, more preferably 2% by mass or more, and even more preferably 3% by mass or more. Meanwhile, in the polishing composition of the present invention, the upper limit of content of the abrasive grain is, relative to the polishing composition, preferably 25% by mass or less, more preferably 20% by mass or less, even more preferably 15% by mass or less, and yet more preferably 12% by mass or less. Within these ranges, the polishing speed can be more enhanced. For the polishing composition containing two or more types of abrasive grain, the content of abrasive grain means the total amount of them.

[Basic inorganic compound]

The polishing composition of the present invention includes the basic inorganic compound. Now, the basic inorganic compound means an inorganic compound that functions, when added to the polishing composition, to elevate pH of the composition. The basic inorganic compound acts to chemically polish the surface of the object to be polished, and acts to improve dispersion stability of the polishing composition. Moreover, the basic inorganic compound contained in the polishing composition of the present invention can increase electrical conductivity of the polishing composition than a basic organic compound can. Hence the polishing speed using the polishing composition is supposedly further enhanced.

Moreover, the basic inorganic compound is less bulky in a three-dimensional sense as compared with the basic organic compound, so that the basic inorganic compound and the anionic water-soluble polymer are less likely to form an aggregate. Hence, the polishing composition of the present invention can keep a stable dispersion state of the anionic water-soluble polymer, and the anionic water-soluble polymer can therefore adhere to the polishing pad efficiently.

The basic inorganic compound is exemplified by alkali metal compounds such as potassium compound and sodium compound, and ammonia. The alkali metal compounds are specifically exemplified by potassium hydroxide, potassium carbonate, potassium hydrogen carbonate, potassium sulfate, potassium acetate, potassium chloride, sodium hydroxide, sodium carbonate, sodium hydrogen carbonate, sodium sulfate, sodium acetate, sodium chloride, and the like. Among them, basic inorganic compound is preferably potassium hydroxide, sodium hydroxide or ammonia, from the viewpoint of pH and stability of slurry, and is more preferably potassium hydroxide or ammonia.

In an embodiment of the present invention, content of the basic inorganic compound in the polishing composition, relative to the polishing composition, is preferably 0.001% by mass or more, more preferably 0.01% by mass or more, even more preferably 0.1% by mass or more, particularly preferably 1.0% by mass or more, and most preferably 1.5% by mass or more. With the lower limit values thus specified, the polishing speed will be improved. The content of the basic inorganic compound in the polishing composition, relative to the polishing composition, is preferably 10% by mass or less, more preferably 8% by mass or less, and even more preferably 6% by mass or less. With such upper limit values thus specified, a stable slurry without causing aggregation is obtainable.

[Anionic Water-Soluble Polymer]

The polishing composition of the present invention contains anionic water-soluble polymer. The anionic water-soluble polymer is a water-soluble polymer having anionic groups in the molecule. In this patent specification, "water-soluble" means that solubility in water (25°C) is 1 g/100 mL or larger. Only one kind of anionic water-soluble polymer may be used independently, or two or more kinds may be used in a combined manner.

When the polishing composition of the present invention is used for polishing the object to be polished, the anionic water-soluble polymer contained in the polishing composition adheres on the polishing pad. The zeta potential of the surface of the pad, having been positive, will shift towards the negative side by adhesion of the anionic water-soluble polymer, meanwhile the zeta potential of the surface of the pad, having been negative, will increase the absolute value thereof by adhesion of the anionic water-soluble polymer. For an exemplary polishing pad composed of polyurethane, the zeta potential of the surface of polyurethane, normally kept at -45 mV or around, can increase up to -80 mV, when the polishing pad is brought into contact with the polishing composition of the present invention (that is, by adhesion of the anionic water-soluble polymer). Hence, through adhesion onto the surface of the polishing pad, the anionic water-soluble polymer shifts the surface charge of the polishing pad towards the negative side, or increases the absolute value of the negative surface charge of the polishing pad, leading the polishing pad and the abrasive grain more repulsive to each other, and increasing the polishing speed.

According to an embodiment of the present invention, the anionic water-soluble polymer is preferably the one containing, in the molecule thereof, at least one functional group selected from the group consisting of carboxy group, sulfo group, phosphoric acid group and phosphonic acid group. Among them, the anionic water-soluble polymer preferably contains carboxy group. With such group contained in the anionic water-soluble polymer, the effects of the present invention will be expressed efficiently.

According to an embodiment of the present invention, the anionic water-soluble polymer preferably has a structural unit derived from a monomer having an ethylenic unsaturated bond. For example, the anionic water-soluble polymer preferably contains, as the monomer-derived structural unit, one or more kinds selected from the group consisting of acrylic acid and methacrylic acid. Hence, the anionic water-soluble polymer is preferably at least one selected from the group consisting of polyacrylate-based polymer and polymethacrylate-based polymer. With such embodiment, the abrasive grain is presumably kept in a stably dispersed manner in the polishing composition, owing to interaction between the carboxy group and the basic inorganic compound.

The anionic water-soluble polymer may be a copolymer that contains, in one molecule thereof, a structural unit derived from a monomer having an ethylenic unsaturated bond, and a structural unit derived from other monomer. Such copolymer is exemplified by copolymer of (meth)acrylic acid and vinyl alcohol, copolymer of (meth)acrylic acid and 2-hydroxy-2-phosphonoacetic acid (HPAA), and copolymer of (meth)acrylic acid and acryloylmorpholine (ACMO), and the like. Note that (meth)acrylic acid collectively means acrylic acid and methacrylic acid.

The anionic water-soluble polymer may also contain an oxyalkylene unit. The oxyalkylene unit possibly contained in the anionic water-soluble polymer is exemplified by polyethylene oxide (PEO), block copolymer of ethylene oxide (EO) and propylene oxide (PO), random copolymer of EO and PO, and the like. The block copolymer of EO and PO may be a diblock copolymer, triblock copolymer and so forth, containing polyethylene oxide (PEO) block and polypropylene oxide (PPO) block. The triblock copolymer encompasses PEO-PPO-PEO type triblock copolymer and PPO-PEO-PPO type triblock copolymer.

In an embodiment of the present invention, the lower limit of molecular weight (mass average molecular weight) of the anionic water-soluble polymer is preferably 1,000 or larger, 5,000 or larger, 10,000 or larger, 50,000 or larger, 100,000 or larger, 300,000 or larger, 500,000 or larger and 800,000 or larger, which are increasingly preferred in this order.

The upper limit of the molecular weight (mass average molecular weight) of the anionic water-soluble polymer is preferably 8,500,000 or smaller, 6,000,000 or smaller, 4,000,000 or smaller, 2,000,000 or smaller and 1,500,000 or smaller increasingly in this order. That is, the molecular weight (mass average molecular weight) of the anionic water-soluble polymer is preferably 1,000 or larger and 8,500,000 or smaller, 5,000 or larger and 6,000,000 or smaller, 10,000 or larger and 4,000,000 or smaller, 50,000 or larger and 4,000,000 or smaller, and 100,000 or larger and 2,000,000 or smaller, which are increasingly preferred in this order. Within these ranges, the polishing speed may further be enhanced. Measured values obtained by the GPC method are employable as the molecular weight (mass average molecular weight) of the anionic water-soluble polymer.

In an embodiment of the present invention, content of the anionic water-soluble polymer in the polishing composition, relative to the polishing composition, is preferably 0.001% by mass or more, more preferably 0.005% by mass or more, even more preferably 0.01% by mass or more, yet more preferably 0.05% by mass or more, and most preferably 0.08% by mass or more. Meanwhile, the content of the anionic water-soluble polymer in the polishing composition, relative to the polishing composition, is 0.8% by mass or less, more preferably 0.5% by mass or less, and particularly preferably 0.4% by mass or less. Within these ranges, a high polishing speed can be retained. For the polishing composition containing two or more kinds of anionic water-soluble polymer, the content of the anionic water-soluble polymer means the total content of these polymers.

In an embodiment of the present invention, for the abrasive grain composed of silica, content of the anionic water-soluble polymer in the polishing composition, relative to the polishing composition, is preferably 0.001% by mass or more, more preferably 0.01% by mass or more, even more preferably 0.1% by mass or more, yet more preferably 0.15% by mass or more, and most preferably 0.2% by mass or more. Meanwhile, for the abrasive grain composed of silica, the content of the anionic water-soluble polymer in the polishing composition, relative to the polishing composition, is 0.8% by mass or less, more preferably 0.5% by mass or less, and particularly preferably 0.4% by mass or less. Within these ranges, a high polishing speed can be retained.

In an embodiment of the present invention, for the abrasive grain composed of alumina, content of the anionic water-soluble polymer in the polishing composition, relative to the polishing composition, is preferably 0.001% by mass or more, more preferably 0.005% by mass or more, even more preferably 0.01% by mass or more, yet more preferably 0.05% by mass or more, and most preferably 0.08% by mass or more. Meanwhile, for the abrasive grain composed of alumina, the content of the anionic water-soluble polymer in the polishing composition, relative to the polishing composition, is 0.8% by mass or less, more preferably 0.5% by mass or less, and particularly preferably 0.4% by mass or less. Within these ranges, a high polishing speed can be retained.

[Dispersing medium]

The polishing composition contains a dispersing medium (solvent) for the purpose of dispersing the individual ingredients composing the polishing composition. The dispersing medium functions to disperse or dissolve the individual ingredients. The dispersing medium is exemplified by organic solvent and water, in which water is preferably contained, and is more preferably water.

From the viewpoint of suppressing pollution of the object to be polished, and from suppressing inhibition of actions of the other ingredients, the dispersing medium is preferably a water free of impurities as possible. Such water is preferably a water having, for example, a total content of transition metal ions of 100 ppb or less. Now the purity of water may be elevated, for example, by operations such as elimination of impurity ions using an ion exchange resin, removal of foreign matter through a filter, and distillation. More specifically, deionized water (ion-exchanged water), pure water, ultrapure water, distilled water and so forth are suitably employed as the water. In most cases, water preferably accounts for the 90% by volume or more of the dispersing medium contained in the polishing composition, water more preferably accounts for 95% by volume or more of that, water even more preferably accounts for 99% by volume or more of that, and water particularly preferably accounts for 100% by volume of that.

The dispersing medium may be a mixed solvent of water and an organic solvent, aiming at dispersing or dissolving the individual ingredients. In this case, the organic solvent employed here is exemplified by acetone, acetonitrile, ethanol, methanol, isopropanol, glycerin, ethylene glycol, propylene glycol and so forth, which are organic solvent miscible with water. Alternatively, these organic solvents may be used without being mixed with water, and may be mixed with water after the individual ingredients are dispersed or dissolved. Only a single kind of these organic solvents may be used independently, or two or more kinds may be used in a combined manner.

[Other Additives]

The polishing composition of the present invention may further contain any of known additives such as pH adjusting agent, chelating agent, thickener, oxidant, dispersion aid, surface protecting agent, wetting agent, surfactant, antirust agent, antiseptic agent, and antifungal agent, so long as the effects of the present invention will not be damaged.

Contents of these additives may suitably be determined, depending on the purpose of addition.

(Oxidant)

The polishing composition of the present invention may contain an oxidant. The oxidant is an ingredient that can enhance an effect of polishing, and is typically water-soluble. Although not interpreted in a specially restricted sense, the oxidant is presumably act to oxidatively modify the surface of the object to be polished during polishing so as to weaken the surface of the object to be polished, thereby contributing to the polishing with the abrasive grain.

The polishing composition of the present invention, with the abrasive grain composed of silica, and with the oxidant contained therein, can enhance the polishing speed on a silicon nitride (SiN) film. The polishing composition of the present invention, with the abrasive grain composed of silica, and with the oxidant contained therein, can also enhance the polishing speed on metal films.

Examples of oxidants include peroxides such as hydrogen peroxide; nitric acid compounds such as nitric acid, as well as iron nitrate, silver nitrate, and aluminum nitrate which are salts thereof and ceric ammonium nitrate which is a complex thereof; persulfuric acid compounds such as persulfuric acids including potassium peroxymonosulfate, peroxodisulfuric acid, and the like, as well as ammonium persulfate and potassium persulfate which are salts thereof; chlorine compounds such as chloric acid, as well as salts thereof, and perchloric acid, as well as potassium perchlorate which is a salt thereof; bromine compounds such as bromic acid, as well as potassium bromate which is a salt thereof; iodine compounds such as iodic acid, as well as ammonium iodate which is a salt thereof, and periodic acid, as well as sodium periodate and potassium periodate which are salts thereof; ferric acids such as ferric acid, as well as potassium ferrate which is a salt thereof; permanganic acids such as permanganic acid, as well as sodium permanganate and potassium permanganate which are salts thereof; chromic acids such as chromic acid, as well as potassium chromate and potassium dichromate which are salts thereof; vanadic acids such as vanadic acid, as well as ammonium vanadate, sodium vanadate, and potassium vanadate which are salts thereof; ruthenium acids such as perruthenium acid and salts thereof; molybdic acids such as molybdic acid, as well as ammonium molybdate and disodium molybdate which are salts thereof; rhenic acids such as perrhenium and salts thereof; and tungstic acids such as tungstic acid, as well as disodium tungstate which is a salt thereof.

Only one kind of these oxidants may be used independently, or two or more kinds may be used in a combined manner. Among them, peroxide, permanganic acid or salt thereof, vanadic acid or salt thereof, and periodic acid or salt thereof are preferred from the viewpoint of polishing efficiency or the like; hydrogen peroxide and potassium permanganate are more preferred; and hydrogen peroxide is even more preferred.

The polishing composition of the present invention, when containing silica (preferably colloidal silica) as the abrasive grain, and with the oxidant (preferably hydrogen peroxide) contained therein, can enhance the polishing speed on the silicon oxide film and silicon nitride film, and can also enhance the polishing speed on metal films (for example, tungsten film). In more detail, the polishing composition of the present invention, by combining therein with silica as the abrasive grain, the basic inorganic compound (preferably potassium hydroxide), and the oxidant (preferably hydrogen peroxide), can enhance the polishing speed on silicon oxide film, silicon nitride film and metal films (for example, tungsten film).

The reason why such effect is demonstrated, although remains unclear, is presumed as follows. With the oxidant contained in the polishing composition, the surface of the object to be polished will be oxidatively modified and weakened as described above. Moreover, the polishing composition having the oxidant contained therein needs a larger content of the basic inorganic compound (in order to attain the same pH value), as compared with the oxidant-free polishing composition. In this case, electrical conductivity of the polishing composition presumably increases, and electrostatic repulsion between the object to be polished and the abrasive grain presumably decreases. This increases probability of collision between the abrasive grain and the object to be polished. Hence, owing to the efficient collision of the abrasive grain on the surface of the object to be polished having been weakened by the oxidant, it now presumably becomes possible to polish silicon oxide film, silicon nitride film, and metal films (for example, tungsten film) efficiently. Note, however, that such mechanism remains a matter of speculation, and as a matter of course does not limit the technical scope of the present invention.

Thus, in one preferable embodiment, the polishing composition includes, silica (preferably colloidal silica) as abrasive grains, a basic inorganic compound (preferably potassium hydroxide), an anionic water-soluble polymer, oxidant (preferably hydrogen peroxide), and a dispersing medium, zeta potential of the abrasive grain is negative, aspect ratio of the abrasive grain is larger than 1.1, and in a particle size distribution of the abrasive grain determined by laser diffraction/scattering method, ratio D90/D50, where D90 represents a particle diameter at which the cumulative particle mass integrated from the small particle side accounts for 90% of the total particle mass, and D50 represents a particle diameter at which the cumulative particle mass integrated from the small particle side accounts for 50% of the total particle mass, is larger than 1.3.

Content (concentration) of the oxidant in the polishing composition is, relative to the polishing composition, preferably 0.03% by mass or more. From the viewpoint of enhancing the polishing speed, the content of oxidant is, relative to the polishing composition, more preferably 0.5% by mass or more, even more preferably 0.8% by mass or more, and particularly 2.5% by mass or more. Meanwhile, from the viewpoint of smoothness of the object to be polished, the content of oxidant is, relative to the polishing composition, preferably 10% by mass or less, more preferably 9% by mass or less, even more preferably 8% by mass or less, and particularly preferably 7% by mass or less.

(pH Adjusting agent)

The polishing composition of the present invention, whose pH might be controlled within a desired range using the basic inorganic compound, may further contain a pH adjusting agent other than the basic inorganic compound.

As the pH adjusting agent, employable are any of known acids, bases other than the basic inorganic compound, or salts of these compounds. Specific examples of the acid that may be used as the pH adjusting agent include an inorganic acid such as hydrochloric acid, sulfuric acid, hydrofluoric acid, boric acid, carbonic acid, hypophosphorous acid, phosphorous acid, and phosphoric acid; and an organic acid such as formic acid, acetic acid, propionic acid, butyric acid, valeric acid, 2-methylbutyric acid, n-hexanoic acid, 3,3-dimethyl-butyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, lactic acid, diglycolic acid, 2-furancarboxylic acid, 2,5-furandicarboxylic acid, 3-furancarboxylic acid, 2-tetrahydrofurancarboxylic acid, methoxyacetic acid, methoxyphenylacetic acid, and phenoxyacetic acid.

The base other than the basic inorganic compound, employable as the pH adjusting agent, is exemplified by basic organic compounds or the like including aliphatic amines such as ethanolamine, and 2-amino-2-ethyl-1,3-propandiol, aromatic amines, quaternary ammonium hydroxide, and the like.

Only one kind of the pH adjusting agent may be used independently, or two or more kinds may be used in a combined manner.

Amount of addition of the pH adjusting agent is not specifically limited, and is properly adjustable so that pH of the polishing composition will fall within a desired range.

The lower limit of pH of the polishing composition is 9 or larger, more preferably 9.5 or larger, even more preferably 10 or larger, and most preferably 11 or larger. With the lower limit thus determined, the polishing speed on the object to be polished can be enhanced. Meanwhile, the upper limit of pH is preferably, but again not specifically limited to, 13 or smaller, more preferably 12.5 or smaller, and even more preferably 12 or smaller. With the upper limit thus determined, stability of the polishing composition can be improved.

pH of the polishing composition can be measured, for example, using a pH meter.

<Method for Manufacturing Polishing Composition>

The polishing composition of the present invention may be manufactured by a method not specifically limited, and is obtainable typically by mixing the abrasive grain, the basic inorganic compound, the anionic water-soluble polymer and other optional additives in the dispersing medium under stirring. The individual ingredients have been detailed previously. The present invention therefore provides a method for manufacturing the polishing composition, including mixing the abrasive grain, the basic inorganic compound, the anionic water-soluble polymer and the dispersing medium.

A temperature during mixing the respective components is not limited particularly, but preferably ranges from 10°C or more and 40°C or less, and they may be heated so as to enhance rates of dissolution. Also, mixing time is not limited particularly as long as the mixing can be done uniformly.

<Polishing Method and Method for Manufacturing Semiconductor Substrate>

The present invention provides a polishing method that includes polishing the object to be polished, using the polishing composition according to an embodiment of the present invention. The present invention also provides a method for manufacturing a semiconductor substrate, containing the aforementioned polishing method.

A polisher may be a general polisher provided with: a holder for holding a substrate or the like which has an object to be polished; a motor or the like which can change its rotation speed; and a polishing table to which a polishing pad (polishing cloth) can be attached.

As the polishing pad, general nonwoven fabric, polyurethane, porous fluororesin and the like can be used with no particular limitation. The polishing pad is preferably provided with grooving, in which polishing liquid can be stored.

Regarding polishing conditions, rotating speed of a polishing table is preferably 10 rpm ($0.17 s^{-1}$) or faster and 500 rpm ($8.3 s^{-1}$) or slower. Pressure applied to the substrate having the object to be polished (polishing pressure) is preferably 0.5 psi (3.4 kPa) or larger and 10 psi (68.9 kPa) or smaller. A method for supplying the polishing composition onto the polishing pad is not also limited particularly, and may be, for example, supplying the polishing composition continuously by a pump or the like. A supplying amount of the polishing composition is not also limited particularly, but it is preferable that a surface of the polishing pad is usually covered with the polishing composition of the present invention.

After completion of polishing, the substrate is washed in running water, and dried on a spin drier or the like by spinning off the droplets adhered thereon, to thereby obtain the substrate having the object to be polished.

The polishing composition of the present invention may be a one-agent type or may also be a multi-agent type such as a two-agent type. In addition, the polishing composition of the present invention may be prepared by diluting a stock solution of the polishing composition by 10 times or greater with a diluent such as water, for example.

The embodiment of the present invention detailed above is merely an illustrative and exemplary one, rather than a limitative one, clearly indicating that the scope of the present invention shall be interpreted on the basis of the attached claims.

EXAMPLES

The present invention will be described in more detail by showing following Examples and Comparative Examples. However, the technical scope of the present invention is not limited only to the following Examples. Incidentally, unless otherwise specified, "%" and "part" respectively mean "% by mass" and "part by mass". In addition, in the below examples, operations were carried out under conditions at a room temperature (20 to 25°C) and relative humidity of 40% RH to 50% RH, unless otherwise specified.

Measurements of the properties of the individual polishing compositions were carried out according to the methods below.

[Measurement of Zeta Potential]

Each polishing composition prepared as described below was loaded on ELS-Z2 from Otsuka Electronics Co., Ltd., and measured by the laser Doppler method (electrophoretic light scattering method), using a flow cell at 25°C. The obtained data was analyzed using the Smoluchowski equation, to calculate the zeta potential of colloidal silica in the polishing composition.

[Aspect Ratio]

Particle shape of the abrasive grain in each polishing composition was observed under a scanning electron microscope (SEM) (Model SU8000, from Hitachi High-Tech Corporation). One hundred abrasive grains were randomly selected on an image observed under the SEM, and the long diameters and the short diameters of them were measured and averaged. The aspect ratio of the abrasive grain was then calculated using the average long diameter and the average short diameter, from the equation below.

Aspect ratio = Average long diameter [$\mu$m]/Average short diameter [$\mu$m]         [Math. 2]

[Measurement of Average Primary Particle Size]

The average primary particle size of the abrasive grain was determined using specific surface area of the abrasive grain, measured according to the BET method using "Flow SorbII 2300" from Micromeritics Instrument Corporation, and density of the abrasive grain.

[Measurement of Average Secondary Particle Size]

The average secondary particle size of the abrasive grain was measured by the light scattering method using laser light, using a measuring instrument "Microtrac MT3000 II (from MicrotracBEL Corporation). For measurement of the average secondary particle size, powdery abrasive grain was dispersed in water, meanwhile the polishing composition was used as it is, or diluted with water. Concurrently, ratio D90/D50, where D90 representing a particle diameter at which the cumulative particle mass integrated from the small particle side accounts for 90% of the total particle mass, and D50 representing a particle diameter at which the cumulative particle mass integrated from the small particle side accounts for 50% of the total particle mass, in the average secondary particle size distribution of the abrasive grain, was calculated by analysis using the measuring instrument.

[Preparation of Polishing Composition]

(Example 1)

A polishing composition was prepared by mixing the individual ingredients and deionized water at room temperature (25°C) under stirring for 30 minutes, so as to adjust the final concentrations of colloidal silica (average primary particle size 70 nm, average secondary particle size 100 nm, average degree of association 1.4) as the abrasive grain to 7.5% by mass, polyacrylic acid (PAA) with a molecular weight (mass average molecular weight) of 1,000,000 as the water-soluble polymer to 0.24% by mass, and potassium hydroxide as the basic compound to 1.7% by mass. pH of the polishing composition, measured using a pH meter, was 11. The zeta potential of colloidal silica in the thus obtained polishing composition, measured according to the aforementioned method, was -47 mV. The particle size of the abrasive grain (colloidal silica) in the polishing composition was the same as that of the aforementioned colloidal silica.

(Examples 2 to 13, Comparative Examples 1 to 10)

Polishing compositions of Examples 2 to 13 and Comparative Examples 1 to 10 were prepared in the same way as in Example 1, except for that the types and contents of the abrasive grain, the water-soluble polymer and the basic compound were varied as summarized in Table 1. In Table 1, TMAH stands for tetramethylammonium hydroxide, PVP stands for polyvinylpyrrolidone, HEC stands for hydroxyethylcellulose, and PEI stands for polyethylenimine. pH of the thus obtained polishing compositions, and, zeta potential, aspect ratio, particle size and D90/D50 of the abrasive grains (colloidal silica) in the polishing compositions are summarized in Table 1 below. The particle size of the abrasive grains (colloidal silica) in the polishing compositions were the same as the particle size of colloidal silica measured before preparing the polishing compositions.

In Table 1, "Broad" in the column headed by Particle size distribution indicates that D90/D50 is larger than 1.3, meanwhile "sharp" indicates that D90/D50 is 1.3 or smaller. Again in Table 1, "Irregular" in the column headed by Particle shape indicates that the aspect ratio is larger than 1.1, meanwhile "Spherical" indicates that the aspect ratio is 1.1 or smaller. In Table 1, "-" indicates absence of the ingredient.

(Examples 14 to 18, Comparative Example 11)

Each fired-and-milled α-alumina was prepared as the abrasive grain. More specifically, as described in paragraph [0013] in JP-A-2006-36864, aluminum hydroxide was fired under conditions involving the firing temperature within the range from 1100 to 1500°C, and the firing time within the range from 1 to 5 hours, and then crushed using 20000 μm-diameter aluminum oxide balls. The abrasive grains (fired-and-ground α-alumina) were thus manufactured by such method for manufacturing alumina particle (grinding method) involving firing, followed by optional grinding. In the manufacture of these abrasive grains, grinding time was controlled so as to obtain the average particle sizes listed in Table 2 below.

Using each of the obtained fired-and-ground α-alumina, each of the polishing compositions of Examples 14 to 18, and Comparative Example 11 was prepared. The average primary particle size, the average secondary particle size, D90/D50 and the aspect ratio of each of the fired-and-ground α-alumina used for each polishing composition were summarized in Table 2. The polishing compositions of Examples 14 to 18 and Comparative Example 11 were prepared in the same way as in Example 1, except for that the types and contents of the abrasive grain, the water-soluble polymer and the basic compound were varied as summarized in Table 2. pH of the obtained polishing compositions, and, the zeta potential, the aspect ratio, the particle size and D90/D50 of the abrasive grains (fired-and-ground α-alumina) in the polishing compositions were summarized in Table 2 below. The particle size, D90/D50 and the aspect ratio of the abrasive grains (fired-and-ground α-alumina) in the polishing compositions were equivalent to the particle size, D90/D50 and the aspect ratio of the fired-and-ground α-alumina measured before preparing the polishing composition. Note that in Table 2, the meaning of notations of "Broad" in the column headed by Particle size distribution, "Irregular" in the column headed by Particle shape, and "-" in the column headed by Water-soluble polymer are same as those in Table 1.

(Example 19)

A polishing composition was prepared by mixing the individual ingredients and deionized water at room temperature (25°C) under stirring for 30 minutes, so as to adjust the final concentrations of colloidal silica (average primary particle size 70 nm, average secondary particle size 100 nm, average degree of association 1.4) as the abrasive grain to 7.5% by mass, polyacrylic acid (PAA) with a molecular weight (mass average molecular weight) of 1,000,000 as the water-soluble polymer to 0.24% by mass, potassium hydroxide as the basic compound to 3.4% by mass, and hydrogen peroxide ($H_2O_2$) as the oxidant to 1.0% by mass. pH of the polishing composition, measured using a pH meter, was 11. pH of the obtained polishing composition, and, the zeta potential, the aspect ratio, the particle size and D90/D50 of the abrasive grain (colloidal silica) in the polishing composition were summarized in Table 4 below. The particle size of the abrasive grain (colloidal silica) in the polishing composition was equivalent to the particle size of colloidal silica measured before preparing the polishing composition. Note that, in Table 4, the meaning of notations of "Broad" in the column headed by Particle size distribution, "Irregular" in the column headed by Particle shape, and "-" in the column headed by Water-soluble polymer are same as those in Table 1.

(Examples 20 to 25, Comparative Examples 12 to 17)

Polishing compositions of Examples 20 to 25 and Comparative Examples 12 to 17 were prepared in the same way as in Example 19, except for that the types and contents of the abrasive grain, the water-soluble polymer, the basic compound and the oxidant were varied as summarized in Table 4. In Table 4, $H_2O_2$ represents hydrogen peroxide, and $KMnO_4$ represents potassium permanganate.

pH of the obtained polishing composition, and, the zeta potential, the aspect ratio, the particle size and D90/D50 of the abrasive grain (colloidal silica) in the polishing composition were summarized in Table 4 below. The particle size of the abrasive grain (colloidal silica) in the polishing composition was equivalent to the particle size of colloidal silica measured before preparing the polishing composition.

[Evaluation]

[Polishing Speed]

A silicon wafer having formed on the surface thereof a 10000 Å thick TEOS film (200 mm, blanket film wafer, from Advantech Co., Ltd.), a silicon wafer having formed on the surface thereof a 3500 Å thick SiN (silicon nitride) film (200 mm, blanket film wafer, from Advantech Co., Ltd.), and a silicon wafer having formed on the surface thereof a 4000 Å thick W (tungsten) film (200 mm, blanket film wafer, from Advantech Co., Ltd.) were prepared, as the object to be polished. These three types of object to be polished were then polished using the individual polishing compositions under polishing conditions described below, for which the TEOS film wafer and the and the SiN film wafer were diced into 60 mm × 60 mm chips to prepare coupon-type test pieces, meanwhile the W film wafer was used as it is as the test piece. The TEOS film wafer and the SiN film wafer were polished using the polishing compositions of Examples 1 to 25 and Comparative Examples 1 to 17, meanwhile the W film wafer was polished using the polishing compositions of Examples 1 and 19 to 25 and Comparative Examples 12 to 17. Note that 1 Å = 0.1 nm.

(Polishing Conditions)

· TEOS film ($SiO_2$ film) wafer

EJ-380IN-CH (from ENGIS JAPAN Corporation) was used as a polisher, and hard polyurethane pad IC1000 (from Rohm & Haas Company) was used as a polishing pad. Polishing was carried out under conditions involving a polishing pressure of 3.05 psi (21.0 kPa), a rotating speed of polishing table of 60 rpm, a rotating speed of carrier of 60 rpm and a supply rate of polishing composition of 100 ml/min, with the polishing time preset to 60 seconds.

· SiN film wafer

EJ-380IN-CH (from ENGIS JAPAN Corporation) was used as a polisher, and hard polyurethane pad IC1000 (from Rohm & Haas Company) was used as a polishing pad. Polishing was carried out under conditions involving a polishing pressure of 4.0 psi (27.6 kPa), a rotating speed of polishing table of 113 rpm, a rotating speed of carrier of 107 rpm and a supply rate of polishing composition of 200 ml/min, with the polishing time preset to 60 seconds.

· W film wafer

Mirra (from Applied Materials, Inc.) was used as a polisher, and hard polyurethane pad IC1000 (from Rohm & Haas Company) was used as a polishing pad. Polishing was carried out under conditions involving a polishing pressure of 4.0 psi (27.6 kPa), a rotating speed of polishing table of 110 rpm, a rotating speed of carrier of 107 rpm and a supply rate of polishing composition of 200 ml/min, with the polishing time preset to 60 seconds.

(Polishing Speed)

The polishing speed (Removal Rate; RR) was calculated by the equation below.

[Math. 3]

$$\text{Polishing speed [Å/min]} = \frac{\text{Film thickness before polishing [Å] - Film thickness after polishing [Å]}}{\text{Polishing time [min]}}$$

Film thicknesses of the TEOS film and the SiN film were determined using a spectroscopic film thickness measurement system (from Dainippon Screen Mfg. Co., Ltd., Model: Lambda Ace VM-2030), and polishing speed was evaluated by dividing difference between the film thicknesses before and after polishing, with the polishing time.

Film thickness of the W film was determined using an automatic feeding resistivity measurement system (VR-120/08S: from Kokusai Electric System Service, Inc.), and polishing speed was evaluated by dividing difference between the film thicknesses before and after polishing, with the polishing time.

Results of evaluation of the polishing speed were summarized in Tables 1, 2 and 5 below.

[Number of Scratches]

Wafers having the object to be polished, on which the number of scratches is evaluated, were prepared. First, a silicon wafer having formed on the surface thereof a 10000 Å thick TEOS film (200 mm, blanket film wafer, from Advantech Co., Ltd.), and a silicon wafer having formed on the surface thereof a 3500 Å thick SiN film (200 mm, blanket film wafer, from Advantech Co., Ltd.) were prepared as the object to be polished. These two types of wafer having the object to be polished were then polished using the individual polishing compositions obtained above in Examples 2 and 14, under polishing conditions described below.

The number of scratches remained after polishing on the surface of the object to be polished was measured using a wafer inspection apparatus "Surfscan (registered trademark) SP2" from KLA-Tencor, Inc., in which coordinates were determined over the entire surfaces on both sides of the object to be polished (but excluding 2 mm-wide rim), and all of the determined coordinates were observed under Review-SEM (RS-6000, from Hitachi High-Tech Corporation), to find the number of scratches. Now, fault having a depth of 10 nm or deeper and shallower than 100 nm, a width of 5 nm or wider and narrower than 500 nm, and a length of 100 μm or longer was counted as a scratch. Results of evaluation are summarized in Table 3.

(Polishing Conditions for Evaluating Number of Scratches)

Polisher: One-side CMP apparatus "Mirra" for 200 mm wafer, from Applied Materials, Inc.
Pad: hard polyurethane pad IC1010, from Nitta Haas Inc.
Polishing pressure: 2.0 psi
Rotating speed of polishing table: 83 rpm
Rotating speed of carrier: 77 rpm
Feeding of polishing composition: free flow
Amount of feed of polishing composition: 200 ml/min
Polishing time: 60 seconds.

[Table 1]

Table 1

| | Abrasive grains (colloidal silica) | | | | | | | | Basic compound | | Water-soluble polymer | | | Properties of polishing composition | | |
| | Average Primary Particle Size [nm] | Average Secondary Particle Size [nm] | D90/D50 | Particle size distribution | Particle Shape | Aspect ratio | Zeta Potential [mV] | Concentration [% by mass] | Type | Concentration [% by mass] | Type | Molecular weight | Concentration [% by mass] | pH | Polishing speed [Å/min] | |
| | | | | | | | | | | | | | | | TEOS | SiN |
|---|---|---|---|---|---|---|---|---|---|---|---|---|---|---|---|---|
| Example 1 | 70 | 100 | 1.7 | Broad | Irregular | 1.25 | -47 | 7.5 | KOH | 1.7 | PAA | 1000000 | 0.24 | 11 | 3918 | 984 |
| Example 2 | 70 | 100 | 1.7 | Broad | Irregular | 1.25 | -47 | 10 | KOH | 1.7 | PAA | 1000000 | 0.24 | 11 | 4706 | 1182 |
| Example 3 | 70 | 100 | 1.7 | Broad | Irregular | 1.25 | -47 | 10 | KOH | 0.1 | PAA | 1000000 | 0.24 | 10 | 3800 | 954 |
| Example 4 | 70 | 100 | 1.7 | Broad | Irregular | 1.25 | -47 | 10 | KOH | 0.1 | PAA | 1000000 | 0.24 | 10.5 | 4400 | 1105 |
| Example 5 | 70 | 100 | 1.7 | Broad | Irregular | 1.25 | -47 | 10 | KOH | 3.4 | PAA | 1000000 | 0.24 | 12 | 4700 | 1180 |
| Example 6 | 70 | 100 | 1.7 | Broad | Irregular | 1.25 | -47 | 10 | KOH | 1.7 | PAA | 1000000 | 0.10 | 11 | 4100 | 1030 |
| Example 7 | 70 | 100 | 1.7 | Broad | Irregular | 1.25 | -47 | 10 | KOH | 1.7 | PAA | 1000000 | 0.17 | 11 | 4451 | 1118 |
| Example 8 | 70 | 100 | 1.7 | Broad | Irregular | 1.25 | -47 | 10 | KOH | 1.7 | PAA | 1000000 | 0.48 | 11 | 4700 | 1180 |
| Example 9 | 70 | 100 | 1.7 | Broad | Irregular | 1.25 | -47 | 10 | KOH | 1.7 | PAA | 200000 | 0.24 | 11 | 4095 | 1029 |
| Example 10 | 70 | 100 | 1.7 | Broad | Irregular | 1.25 | -47 | 10 | KOH | 1.7 | PAA | 500000 | 0.24 | 11 | 4500 | 1130 |
| Example 11 | 70 | 100 | 1.7 | Broad | Irregular | 1.25 | -47 | 10 | KOH | 1.7 | PAA | 3000000 | 0.24 | 11 | 4300 | 1080 |
| Example 12 | 70 | 100 | 1.7 | Broad | Irregular | 1.25 | -47 | 10 | KOH | 1.7 | PAA | 5000000 | 0.1 | 11 | 3900 | 980 |
| Example 13 | 70 | 100 | 1.7 | Broad | Irregular | 1.25 | -47 | 10 | KOH | 1.7 | PAA | 3000 | 0.24 | 11 | 3575 | 898 |
| Comparative Example 1 | 70 | 100 | 1.7 | Broad | Irregular | 1.25 | -45 | 10 | - | - | - | - | - | 8 | 1700 | 427 |
| Comparative Example 2 | 70 | 100 | 1.7 | Broad | Irregular | 1.25 | -47 | 10 | KOH | 1.7 | - | - | - | 11 | 3120 | 784 |
| Comparative Example 3 | 90 | 170 | 1.3 | Sharp | Spherical | 1.1 | -45 | 10 | KOH | 1.7 | PAA | 1000000 | 0.24 | 11 | 3200 | 879 |
| Comparative Example 4 | 35 | 60 | 1.2 | Sharp | Irregular | 1.7 | -45 | 10 | KOH | 1.7 | PAA | 1000000 | 0.24 | 11 | 2200 | 553 |
| Comparative Example 5 | 50 | 100 | 1.9 | Broad | Spherical | 1.1 | -30 | 10 | KOH | 1.7 | PAA | 1000000 | 0.24 | 11 | 2600 | 653 |

EP 3 792 327 B1

16

(continued)

| | Abrasive grains (colloidal silica) | | | | | | | | Basic compound | | Water-soluble polymer | | | Properties of polishing composition | | |
|---|---|---|---|---|---|---|---|---|---|---|---|---|---|---|---|---|
| | Average Primary Particle Size [nm] | Average Secondary Particle Size [nm] | D90/D50 | Particle size distribution | Particle Shape | Aspect ratio | Zeta Potential [mV] | Concentration [% by mass] | Type | Concentration [% by mass] | Type | Molecular weight | Concentration [% by mass] | pH | Polishing speed [Å/min] | |
| | | | | | | | | | | | | | | | TEOS | SiN |
| Comparative Example 6 | 70 | 100 | 1.7 | Broad | Irregular | 1.25 | -47 | 10 | TMAH | 1.7 | PAA | 1000000 | 0.24 | 11 | 2200 | 553 |
| Comparative Example 7 | 70 | 100 | 1.7 | Broad | Irregular | 1.25 | -47 | 10 | Piperazine | 1.7 | PAA | 1000000 | 0.24 | 11 | 200 | 50 |
| Comparative Example 8 | 70 | 100 | 1.7 | Broad | Irregular | 1.25 | -30 | 10 | KOH | 1.7 | PVP | 40000 | 0.24 | 11 | 1800 | 452 |
| Comparative Example 9 | 70 | 100 | 1.7 | Broad | Irregular | 1.25 | -30 | 10 | KOH | 1.7 | HEC | 100000 | 0.24 | 11 | 1650 | 414 |
| Comparative Example 10 | 70 | 100 | 1.7 | Broad | Irregular | 1.25 | -30 | 10 | KOH | 1.7 | PEI | 10000 | 0.24 | 11 | 350 | 88 |

[Table 2]

[Table 2]

Table 2

| | Abrasive grains (fired-and-ground α-alumina) | | | | | | | | Basic compound | | Water-soluble polymer | | | Properties of polishing composition | | |
|---|---|---|---|---|---|---|---|---|---|---|---|---|---|---|---|---|
| | Average Primary Particle Size [nm] | Average Secondary Particle Size [nm] | D90/D50 | Particle size distribution | Particle Shape | Aspect ratio | Zeta Potential [mV] | Concentration [% by mass] | Type | Concentration [% by mass] | Type | Molecular weight | Concentration [% by mass] | pH | Polishing speed [Å/min] | |
| | | | | | | | | | | | | | | | TEOS | SiN |
| Comparative Example 11 | 345 | 800 | 1.6 | Broad | Irregular | 3.5 | -30 | 10 | KOH | 1.7 | - | - | - | 11 | 2500 | 500 |
| Example 14 | 345 | 800 | 1.6 | Broad | Irregular | 3.5 | -30 | 10 | KOH | 1.7 | PAA | 1000000 | 0.1 | 11 | 3800 | 800 |
| Example 15 | 1000 | 3000 | 3.0 | Broad | Irregular | 3.5 | -30 | 10 | KOH | 1.7 | PAA | 1000000 | 0.1 | 11 | 5600 | 1404 |
| Example 16 | 345 | 1280 | 1.6 | Broad | Irregular | 3.5 | -30 | 10 | KOH | 1.7 | PAA | 1000000 | 0.1 | 11 | 4580 | 1255 |
| Example 17 | 1000 | 3000 | 3.0 | Broad | Irregular | 3.5 | -30 | 10 | $NH_3$ | 1.7 | PAA | 1000000 | 0.1 | 11 | 4900 | 1190 |
| Example 18 | 1000 | 3000 | 3.0 | Broad | Irregular | 3.5 | -5 | 10 | KOH | 1.7 | PAA | 1000000 | 0.1 | 9 | 3000 | 550 |

[Table 3]

Table 3

| | Abrasive grain | | | | Properties of polishing composition | | |
|---|---|---|---|---|---|---|---|
| | Type | Average Primary Particle Size [nm] | Average Secondary Particle Size [nm] | Aspect ratio | Polishing speed [Å/min] | | Number of scratches TEOS |
| | | | | | TEOS | SiN | |
| Example 2 | Colloidal silica | 70 | 100 | 1.25 | 4706 | 1182 | 1 |
| Example 14 | Fired-and-ground α-alumina | 345 | 800 | 3.5 | 3800 | 800 | 70 |

[Table 4]

Table 4

| | Abrasive grains (colloidal silica) | | | | | | | | Basic compound | | Water-soluble polymer | | | Oxidant | |
|---|---|---|---|---|---|---|---|---|---|---|---|---|---|---|---|
| | Average Primary Particle Size [nm] | Average Secondary Particle Size [nm] | D90/D50 | Particle size distribution | Particle Shape | Aspect ratio | Zeta Potential [mV] | Concentration [% by mass] | Type | Concentration [% by mass] | Type | Molecular weight | Concentration [% by mass] | Type | Concentration [% by mass] |
| Example 19 | 70 | 100 | 1.7 | Broad | Irregular | 1.25 | -47 | 7.5 | KOH | 3.4 | PAA | 1000000 | 0.24 | $H_2O_2$ | 1.0 |
| Example 20 | 70 | 100 | 1.7 | Broad | Irregular | 1.25 | -47 | 7.5 | KOH | 1.7 | PAA | 1000000 | 0.24 | $H_2O_2$ | 1.0 |
| Example 1 | 70 | 100 | 1.7 | Broad | Irregular | 1.25 | -47 | 7.5 | KOH | 1.7 | PAA | 1000000 | 0.24 | - | - |
| Example 21 | 70 | 100 | 1.7 | Broad | Irregular | 1.25 | -47 | 7.5 | KOH | 3.4 | PAA | 1000000 | 0.24 | - | - |
| Example 22 | 70 | 100 | 1.7 | Broad | Irregular | 1.25 | -47 | 7.5 | KOH | 3.4 | PAA | 1000000 | 0.24 | $H_2O_2$ | 3.0 |
| Example 23 | 70 | 100 | 1.7 | Broad | Irregular | 1.25 | -47 | 7.5 | KOH | 4.4 | PAA | 1000000 | 0.24 | $H_2O_2$ | 5.0 |
| Example 24 | 70 | 100 | 1.7 | Broad | Irregular | 1.25 | -47 | 7.5 | KOH | 5.0 | PAA | 1000000 | 0.24 | $H_2O_2$ | 7.0 |
| Example 25 | 70 | 100 | 1.7 | Broad | Irregular | 1.25 | -47 | 7.5 | KOH | 3.0 | PAA | 1000000 | 0.24 | $KMnO_4$ | 0.5 |
| Comparative Example 12 | 70 | 100 | 1.7 | Broad | Irregular | 1.25 | -47 | 7.5 | KOH | 1.7 | - | - | - | - | - |
| Comparative Example 13 | 70 | 100 | 1.7 | Broad | Irregular | 1.25 | -47 | 7.5 | KOH | 3.4 | - | - | - | $H_2O_2$ | 3.0 |
| Comparative Example 14 | 70 | 100 | 1.7 | Broad | Irregular | 1.25 | -47 | 7.5 | KOH | 3.4 | - | - | - | - | - |
| Comparative Example 15 | 70 | 100 | 1.7 | Broad | Irregular | 1.25 | -47 | 7.5 | KOH | 4.4 | - | - | - | - | - |
| Comparative Example 16 | 70 | 100 | 1.7 | Broad | Irregular | 1.25 | -47 | 7.5 | KOH | 1.7 | - | - | - | $H_2O_2$ | 1.0 |
| Comparative Example 17 | 70 | 100 | 1.7 | Broad | Irregular | 1.25 | -47 | 7.5 | KOH | 3.4 | - | - | - | $H_2O_2$ | 1.0 |

[Table 5]

Table 5

| | Properties of polishing composition | | | |
|---|---|---|---|---|
| | pH | Polishing speed [Å/min] | | |
| | | TEOS | SiN | W |
| Example 19 | 11 | 3920 | 1105 | 330 |
| Example 20 | 10 | 3780 | 1040 | 332 |
| Example 1 | 11 | 3918 | 984 | 23 |
| Example 21 | 12 | 4040 | 985 | 22 |
| Example 22 | 11 | 3933 | 1255 | 440 |
| Example 23 | 11 | 3925 | 1244 | 480 |
| Example 24 | 11 | 3922 | 1247 | 540 |
| Example 25 | 11 | 3908 | 1242 | 380 |
| Comparative Example 12 | 11 | 2610 | 632 | 52 |
| Comparative Example 13 | 11 | 2605 | 883 | 550 |
| Comparative Example 14 | 12 | 2820 | 643 | 51 |
| Comparative Example 15 | 12.5 | 2993 | 703 | 48 |
| Comparative Example 16 | 10 | 2510 | 665 | 423 |
| Comparative Example 17 | 11 | 2580 | 692 | 418 |

As summarized in Table 1, when the polishing compositions of Examples 1 to 13 were used, it has been found that the polishing speed on the TEOS film was faster than 3500 Å/min, and the polishing speed on the SiN film was faster than 890 Å/min, proving capability of polishing both objects to be polished at higher speeds, as compared with the polishing compositions of Comparative Examples 1 to 10. That is, it has been found that the TEOS film and the SiN film, as the objects to be polished, were polished efficiently, by using the polishing compositions that contain silica with predetermined shape and predetermined particle size distribution, the basic inorganic compound, and the anionic water-soluble polymer.

It is understood from comparison between Example 1 and Comparative Example 1 that the polishing speed distinctively declined when the polishing composition did not contain the basic inorganic compound. It is also understood from comparison between Example 1 and Comparative Example 2 that the polishing speed clearly declined when the polishing composition did not contain the anionic water-soluble polymer.

From comparison between Example 1 and Comparative Examples 6, 7, the polishing speed demonstrated by the polishing compositions was found to distinctively decline when the basic compound contained in the polishing compositions was not the basic inorganic compound. From comparison between Example 1 between Comparative Examples 8 to 10, the polishing speed demonstrated by the polishing compositions of Comparative Examples 8 to 10, containing the water-soluble polymer other than the anionic water-soluble polymer (nonionic water-soluble polymer, cationic water-soluble polymer), was found to clearly decline.

As summarized in Table 2, when the polishing compositions of Examples 14 to 18 were used, it has been found that the polishing speed on the TEOS film was faster than 3000 Å/min, and the polishing speed on the SiN film was faster than 600 Å/min, proving capability of polishing both objects to be polished at higher speeds, as compared with the polishing composition of Comparative Example 11. That is, it has been found that the TEOS film and the SiN film, as the objects to be polished, were polished efficiently, by using the polishing compositions that contain alumina with predetermined shape and predetermined particle size distribution, the basic inorganic compound, and the anionic water-soluble polymer.

As summarized in Table 3, polishing using the polishing compositions of Example 2 and Example 14 revealed that the polishing composition of Example 14 was more likely to produce scratches as compared with the polishing composition of Example 2. This is presumably because the abrasive grain, being an irregular shaped particle, is less likely to tumble, and scratches therefore became more likely to be produced by alumina which is harder than silica.

From the results, it is understood that the polishing speed on the object to be polished is enhanced when the polishing composition contains the basic inorganic compound and the anionic water-soluble polymer.

As summarized in Table 5, when the polishing compositions of Examples 19, 20, 22 to 25 were used, the polishing speed on the TEOS film was faster than 3500 Å/min, the polishing speed on the SiN film was faster than 1000 Å/min, and the polishing speed on the W film was faster than 300 Å/min. This has proved that the TEOS film, the SiN film and the W film, as the objects to be polished, were polished efficiently, by using the polishing compositions that contain, as the abrasive grain, silica with predetermined shape and predetermined particle size distribution, the basic inorganic compound and the anionic water-soluble polymer, and further contain the oxidant.

It should be noted that the present application is based on Japanese Patent Application No. 2019-165111 filed on September 11, 2019, Japanese Patent Application No. 2020-032253 filed on February 27, 2020, and Japanese Patent Application No. 2020-095479 filed on June 1, 2020.

**Claims**

1. A polishing composition comprising an abrasive grain, a basic inorganic compound, an anionic water-soluble polymer, and a dispersing medium,

    wherein zeta potential of the abrasive grain is negative,
    aspect ratio of the abrasive grain is larger than 1.1, and
    in a particle size distribution of the abrasive grain determined by laser diffraction/scattering method, ratio D90/D50, where D90 represents a particle diameter at which cumulative particle mass integrated from a small particle side accounts for 90% of the total particle mass, and D50 represents a particle diameter at which the cumulative particle mass integrated from the small particle side accounts for 50% of the total particle mass, is 1.6 or larger,

    wherein in the particle size distribution of the abrasive grain determined by laser diffraction/scattering method, diameter D50, representing a particle diameter at which the cumulative particle mass integrated from the small particle side accounts for 50% of the total particle mass, is 70 nm or larger, wherein a pH is 9 or larger.

2. The polishing composition according to claim 1, wherein the anionic water-soluble polymer is at least one selected from the group consisting of polyacrylate-based polymer and polymethacrylate-based polymer.

3. The polishing composition according to claim 1 or 2, wherein molecular weight of the anionic water-soluble polymer is 5,000 or larger and 6,000,000 or smaller.

4. The polishing composition according to any one of claims 1 to 3, wherein the abrasive grain contains colloidal silica.

5. The polishing composition according to claim 4, further comprising an oxidant.

6. The polishing composition according to any one of claims 1 to 3, wherein the abrasive grain contains alumina.

7. The polishing composition according to claim 6, wherein in the particle size distribution of the abrasive grain determined by laser diffraction/scattering method, diameter D50, representing a particle diameter at which the cumulative particle mass integrated from the small particle side accounts for 50% of the total particle mass, is 100 nm or larger.

8. The polishing composition according to any one of claims 1 to 7, wherein the polishing composition is used for polishing an object to be polished that contains silicon oxide.

9. A polishing method comprising polishing an object to be polished, using the polishing composition according to any one of claims 1 to 8.

10. A method for manufacturing a semiconductor substrate, comprising the polishing method according to claim 9.

**Patentansprüche**

1. Polierzusammensetzung, umfassend ein Schleifkorn, eine basische anorganische Verbindung, ein anionisches wasserlösliches Polymer und ein Dispersionsmedium,

> wobei das Zeta-Potential des Schleifkorns negativ ist,
> das Seitenverhältnis des Schleifkorns größer als 1,1 ist und
> in einer Partikelgrößenverteilung des Schleifkorns, die durch Laserbeugungs-/Streuungsverfahren bestimmt wird, das Verhältnis D90/D50, wobei D90 einen Partikeldurchmesser darstellt, bei dem die kumulative Partikelmasse, die von der Seite der kleinen Partikel integriert wird, 90 % der gesamten Partikelmasse ausmacht, und D50 einen Partikeldurchmesser darstellt, bei dem die kumulative Partikelmasse, die von der Seite der kleinen Partikel integriert wird, 50 % der gesamten Partikelmasse ausmacht, 1,6 oder größer ist,
> wobei in der Partikelgrößenverteilung des Schleifkorns, die durch Laserbeugungs-/Streuungsverfahren bestimmt wird, der Durchmesser D50, der einen Partikeldurchmesser darstellt, bei dem die kumulative Partikelmasse, die von der Seite der kleinen Partikel integriert wird, 50 % der gesamten Partikelmasse ausmacht, 70 nm oder größer ist,
> wobei ein pH-Wert von 9 oder größer vorliegt.

2. Die Polierzusammensetzung nach Anspruch 1, wobei das anionische wasserlösliche Polymer mindestens eines ist, ausgewählt aus der Gruppe, bestehend aus Polymeren auf Polyacrylatbasis und Polymeren auf Polymethacrylatbasis.

3. Die Polierzusammensetzung nach Anspruch 1 oder 2, wobei das Molekulargewicht des anionischen wasserlöslichen Polymers 5.000 oder größer und 6.000.000 oder kleiner ist.

4. Die Polierzusammensetzung nach irgendeinem der Ansprüche 1 bis 3, wobei das Schleifkorn kolloidale Kieselsäure enthält.

5. Die Polierzusammensetzung nach Anspruch 4, weiter umfassend ein Oxidationsmittel.

6. Die Polierzusammensetzung nach einem der Ansprüche 1 bis 3, wobei das Schleifkorn Aluminiumoxid enthält.

7. Die Polierzusammensetzung nach Anspruch 6, wobei in der Partikelgrößenverteilung des Schleifkorns, die durch Laserbeugungs-/Streuungsverfahren bestimmt wird, der Durchmesser D50, der einen Partikeldurchmesser darstellt, bei dem die kumulative Partikelmasse, die von der Seite der kleinen Partikel integriert wird, 50 % der gesamten Partikelmasse ausmacht, 100 nm oder größer ist.

8. Die Polierzusammensetzung nach irgendeinem der Ansprüche 1 bis 7, wobei die Polierzusammensetzung zum Polieren eines zu polierenden Gegenstands verwendet wird, der Siliziumoxid enthält.

9. Polierverfahren, umfassend das Polieren eines zu polierenden Objekts unter Verwenden der Polierzusammensetzung nach irgendeinem der Ansprüche 1 bis 8.

10. Verfahren zum Herstellen eines Halbleitersubstrats, umfassend das Polierverfahren nach Anspruch 9.

**Revendications**

1. Composition de polissage comprenant un grain abrasif, un composé inorganique basique, un polymère hydrosoluble anionique et un milieu de dispersion,

> dans laquelle le potentiel zêta du grain abrasif est négatif,
> le rapport d'aspect du grain abrasif est supérieur à 1,1 et
> dans une distribution granulométrique du grain abrasif déterminée par une méthode de diffraction/diffusion laser, le rapport D90/D50, dans lequel D90 représente un diamètre de particule auquel la masse cumulée de particules intégrée du côté des petites particules constitue 90 % de la masse totale des particules, et D50 représente un diamètre de particule auquel la masse cumulée de particules intégrée du côté des petites particules constitue 50 % de la masse totale des particules, est supérieur ou égal à 1,6,
> dans laquelle dans la distribution granulométrique du grain abrasif déterminée par une méthode de diffraction/-diffusion laser, le diamètre D50, qui représente un diamètre de particule auquel la masse cumulée de particules intégrée du côté des petites particules constitue 50 % de la masse totale des particules, est supérieur ou égal à 70 nm,
dans laquelle un pH est supérieur ou égal à 9.

2. Composition de polissage selon la revendication 1, dans laquelle le polymère hydrosoluble anionique est l'un au moins choisi dans le groupe constitué par un polymère à base de polyacrylate et un polymère à base de polyméthacrylate.

3. Composition de polissage selon la revendication 1 ou 2, dans laquelle la masse moléculaire du polymère hydrosoluble anionique est supérieure ou égale à 5 000 et inférieure ou égale à 6 000 000.

4. Composition de polissage selon l'une quelconque des revendications 1 à 3, dans laquelle le grain abrasif contient de la silice colloïdale.

5. Composition de polissage selon la revendication 4, comprenant en outre un oxydant.

6. Composition de polissage selon l'une quelconque des revendications 1 à 3, dans laquelle le grain abrasif contient de l'alumine.

7. Composition de polissage selon la revendication 6, dans laquelle dans la distribution granulométrique du grain abrasif déterminée par une méthode de diffraction/diffusion laser, le diamètre D50, qui représente un diamètre de particule auquel la masse cumulée de particules intégrée du côté des petites particules constitue 50 % de la masse totale des particules, est supérieur ou égal à 100 nm.

8. Composition de polissage selon l'une quelconque des revendications 1 à 7, la composition de polissage étant utilisée pour polir un objet devant être poli qui contient de l'oxyde de silicium.

9. Procédé de polissage comprenant le polissage d'un objet devant être poli, à l'aide de la composition de polissage selon l'une quelconque des revendications 1 à 8.

10. Procédé de fabrication d'un substrat semi-conducteur, comprenant le procédé de polissage selon la revendication 9.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001185516 A
- EP 3261114 A1
- JP 2005162533 A
- JP 2006036864 A
- JP 2019165111 A
- JP 2020032253 A
- JP 2020095479 A

**Non-patent literature cited in the description**

- Sulfonic acid-functionalized silica through of thiol groups. *Chem. Commun.*, 2003, 246-247
- Novel Silane Coupling Agents Containing a Photolabile 2-Nitrobenzyl Ester for Introduction of a Carboxy Group on the Surface of Silica Gel. *Chemistry Letters*, 2000, vol. 3, 228-229